# FASCICULE DE BREVET EUROPEEN

(11) **EP 1 309 005 B1**
(45) Date de publication et mention de la délivrance du brevet: **19.05.2010**
(21) Numéro de dépôt: 02354167.5
(22) Date de dépôt: 21.10.2002
(51) Int. Cl.: H01L 27/02

(54) **Protection d'un circuit intégré contre des décharges électrostatiques et autres surtensions**
Schutz einer integrierten Schaltung gegen ESD und andere Überspannungen
Protection of an integrated circuit against ESD and other overvoltages

(30) Priorité: 23.10.2001 FR 0113675
(43) Date de publication de la demande: 07.05.2003
(73) Titulaire: STMicroelectronics S.A., 92120 Montrouge (FR)
(72) Inventeur: Malherbe, Alexandre, 13530 Trets (FR); Blisson, Fabrice, 13100 Aix en Provence (FR)
(74) Mandataire: de Beaumont, Michel

(56) Documents cités:
- EP-A- 0 412 561
- WO-A-96/36988
- US-A- 5 237 395
- US-A- 5 361 185
- US-B1- 6 258 672

## Description

La présente invention concerne la protection d'un circuit intégré contre des décharges électrostatiques et autres surtensions. L'invention concerne, plus particulièrement, l'intégration des circuits nécessaires à une telle protection.

Les circuits de protection contre des décharges électrostatiques (protection ESD) ont pour but de protéger un circuit électronique contre des décharges électrostatiques susceptibles de provenir de ses bornes.

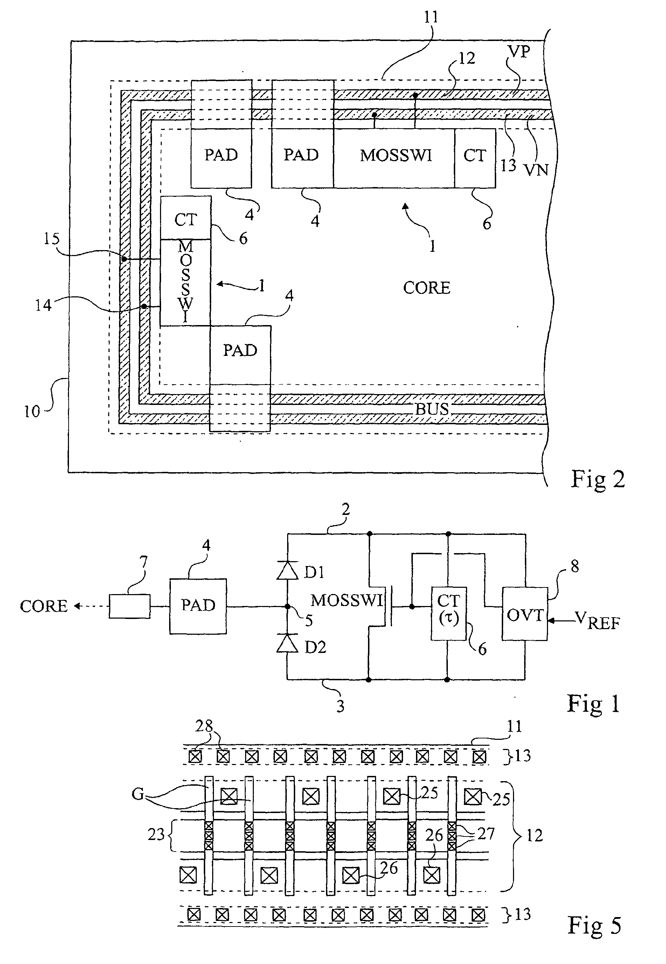

La figure 1 illustre de façon schématique un exemple classique d'un circuit 1 de protection électronique. Le rôle de ce circuit est notamment de court-circuiter des lignes 2, 3 d'alimentation du circuit intégré lorsque apparaît une surtension liée à une décharge électrostatique appliquée à un plot 4 (PAD) du circuit. Ce plot est destiné à relier le coeur (CORE) du circuit intégré (non représenté) à l'extérieur. Le circuit 1 de protection comporte deux diodes D1, D2 en série reliant les lignes d'alimentation 2 et 3. Le point milieu 5 de cette association en série est relié électriquement au plot 4. La polarité des diodes D1 et D2 est telle que, en fonctionnement normal, elles soient bloquées. Par conséquent, dans l'exemple de la figure 1, la ligne 2 constitue la ligne d'alimentation plus positive tandis que la ligne 3 constitue la ligne d'alimentation plus négative (généralement la masse). Le circuit 1 comporte également un transistor MOS MOSSWI reliant les lignes d'alimentation 2 et 3 et dont la grille est reliée à au moins un circuit 6 de commande en protection ESD.

Les perturbations de type électrostatiques susceptibles d'être reçues par les plots 4 peuvent être constituées de charges positives ou négatives. Quand de telles charges apparaissent, l'une des deux diodes D1 ou D2 devient conductrice. Le transistor MOSSWI doit alors être rendu passant pour court-circuiter les lignes d'alimentation 2 et 3 et évacuer ainsi les charges en excès. En évacuant les charges par le transistor MOSSWI, on évite qu'elles ne viennent endommager le coeur. Pour garantir que le chemin électrique constitué de la diode D1 ou D2 soit moins résistif que le passage par le coeur du circuit, on prévoit une résistance 7 entre chaque plot 4 et le coeur du circuit intégré.

Le circuit 6 (CT) a donc pour rôle essentiel de fixer une constante de temps (τ) de déclenchement du transistor MOSSWI à l'apparition d'une décharge électrostatique, c'est-à-dire d'un courant circulant dans l'une des diodes D1 ou D2. Le circuit 6 est généralement constitué d'un circuit résistif et capacitif (cellule RC).

Les transistors MOSSWI de court-circuit des conducteurs d'alimentation peuvent également servir de protection contre d'éventuelles surtensions par rapport au maximum admissible par la technologie du circuit intégré. Dans ce cas, un circuit de commande additionnel 8 (OVT) a pour rôle de détecter d'éventuelles surtensions (par exemple, par rapport à un seuil de tension Vref prédéterminé) et de rendre passant le transistor MOSSWI auquel le circuit est associé. On protège ainsi le circuit intégré non seulement contre des décharges électrostatiques mais également contre toute surtension quelle qu'en soit l'origine.

On fera par la suite référence à des circuits de protection électronique pour englober la protection contre des décharges électrostatiques (ESD) et, sauf précision contraire, la protection contre d'autres surtensions.

Parmi les caractéristiques que doit respecter un circuit 1 de protection électronique, on notera :

Le fait que le transistor MOSSWI doit présenter une résistance à l'état passant (RdsON) la plus faible possible pour remplir correctement son rôle de protection et éviter que la surtension se propage au reste du circuit. Il en découle que le transistor MOSSWI (généralement, un transistor MOS à canal N) est de taille importante pour pouvoir évacuer rapidement les charges en excès.

Le circuit de commande 6 chargé de détecter les surtensions doit généralement présenter une constante de temps faible (la plus souvent inférieure à 200 ns).

De ce qui précède, il découle que l'on cherche généralement à placer le transistor MOSSWI d'un circuit de protection le plus près du plot ou des plots 4 qu'il est censé protéger. Ceci, afin de minimiser la résistance apportée par les lignes d'alimentation elles-mêmes et par les tronçons présents entre les plots et les bornes du transistor.

De plus, le ou les circuits de commande eux-mêmes doivent classiquement également être placés le plus près possible du transistor MOSSWI afin, là encore, de minimiser la résistance due au trajet conducteur entre ces circuits et la grille du transistor MOSSWI formant généralement l'élément capacitif du circuit de commande 6.

La figure 2 illustre, par une vue de dessus partielle et très schématique, un exemple classique de réalisation d'un circuit intégré 10 dont des plots 4 sont associés à des circuits de protection ESD. Dans l'exemple de la figure 2, on a illustré trois plots 4 (PAD) et deux circuits 1 de protection ESD. Pour les raisons de proximité exposées ci-dessus, les circuits 1 de protection sont généralement placés dans ce que l'on appelle une couronne du circuit intégré. Cette couronne entoure le coeur (CORE) du circuit intégrant les différentes fonctions liées à l'application propre du circuit intégré.

La couronne du circuit 10 comporte généralement ce que l'on appelle un rail 11 (BUS) d'alimentation qui comprend au moins deux conducteurs 12, 13 véhiculant les potentiels VP et VN respectivement plus positif et plus négatif d'alimentation du circuit intégré. Le cas échéant, le rail d'alimentation 11 peut comprendre d'autres conducteurs, par exemple, si le circuit intégré possède une tension d'alimentation positive, une masse et une tension d'alimentation négative.

Le rail d'alimentation peut n'être que partiel en périphérie ou être disposé différemment dans le circuit intégré (par exemple, au centre). La notion de coeur englobe, quelle qu'en soit la position, les éléments intégrés remplissant les différentes fonctions liées à l'application propre au circuit intégré et alimentés par un rail de forme quelconque.

Chaque transistor MOSSWI d'un circuit 1 est relié, respectivement par un conducteur 14, 15, au conducteur 12, 13 du rail d'alimentation. De même, chaque plot 4 est relié aux conducteurs 12 et 13 par l'intermédiaire de diodes (D1, D2, figure 1) non représentées en figure 2.

Du point de vue des plots de connexion, on distingue généralement deux grandes familles de circuit intégré.

Une première famille comprend des circuits généralement désignés par l'expression anglo-saxonne "PAD LIMITED". Elle regroupe les circuits intégrés dans lesquels le nombre important de plots de connexion vers l'extérieur du coeur du circuit intégré conditionne la taille du circuit intégré lui-même en raison du périmètre nécessaire pour aligner tous les plots.

Une deuxième famille de circuit comprend les circuits généralement désignés par l'appellation anglo-saxonne "CORE LIMITED" dont la taille est limitée par la surface du coeur et non par le périmètre nécessaire pour aligner les plots.

Dans les circuits de la première famille, on dispose dans le coeur des circuits intégrés de toute la place nécessaire pour réaliser, en nombre suffisant, des transistors MOSSWI et leurs circuits de commande afin de protéger correctement le circuit intégré contre les décharges électrostatiques.

Par contre, dans les circuits dont la taille est déjà conditionnée par le coeur du circuit intégré, il est préjudiciable à l'encombrement global du circuit de devoir augmenter cette taille du coeur pour réaliser les transistors MOSSWI des circuits de protection ESD. Typiquement, ces circuits de protection peuvent représenter jusqu'à 10 % de la taille du coeur de la puce, ce qui nuit à la miniaturisation généralement recherchée.

Le document WO-A-96/36988 décrit des circuits de protection contre les décharges électrostatiques à base de thyristors placés entre les rails d'alimentation du circuit intégré.

Le document US-A-5 237 395 décrit des circuits de protection contre des décharges électrostatiques constitués de transistors MOS placés entre les rails d'alimentation.

La présente invention vise à proposer un circuit intégré à élément de protection électronique d'encombrement restreint.

L'invention vise, plus particulièrement, à réduire l'encombrement global d'un circuit intégré de type CORE LIMITED équipé d'éléments de protection électronique.

L'invention vise également à proposer une solution qui ne nuise pas à la qualité de la protection ESD voire même qui l'améliore.

L'invention vise également à proposer une solution qui permette de protéger le circuit intégré contre tout type de surtension.

L'invention vise en outre à proposer une solution qui soit compatible avec les techniques actuelles de fabrication des circuits intégrés.

Pour atteindre ces objets et d'autres, la présente invention prévoit un circuit intégré comprenant au moins un élément de protection électronique dudit circuit constitué d'au moins un commutateur de court-circuit de conducteurs d'alimentation disposés en rail, ledit commutateur étant intégré dans ledit rail, sous lesdits conducteurs.

Selon un mode de réalisation de la présente invention, plusieurs commutateurs sont commandés par au moins un premier circuit commun.

Selon un mode de réalisation de la présente invention, ledit premier circuit détecte l'apparition de charges électrostatiques.

Selon un mode de réalisation de la présente invention, le circuit comporte en outre au moins un deuxième circuit de commande détectant l'apparition de surtensions entre lesdits conducteurs d'alimentation.

Selon un mode de réalisation de la présente invention, le ou les circuits de commande des commutateurs de court-circuit sont situés dans un coeur du circuit intégré.

Selon un mode de réalisation de la présente invention, les commutateurs sont constitués de transistors MOS dont les drains et sources respectifs sont connectés à l'un de deux conducteurs d'alimentation du circuit intégré.

Selon un mode de réalisation de la présente invention, un conducteur additionnel de commande des grilles des transistors MOS est prévu dans le rail d'alimentation.

L'invention prévoit également un procédé d'intégration de commutateurs de court-circuit de conducteurs d'alimentation disposés en rail, consistant à réaliser les commutateurs sous forme de transistors MOS sous les conducteurs d'alimentation du rail.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente le schéma électrique d'un circuit de protection contre des décharges électrostatiques et autres surtensions ;
la figure 2 décrite précédemment illustre un exemple de disposition classique de circuits de protection contre des décharges électrostatiques dans un circuit intégré ;
la figure 3 représente, par une vue de dessus très schématique, un mode de disposition de circuits de protection électronique selon la présente invention ;
la figure 4 est une vue partielle en perspective et en coupe illustrant un premier mode de réalisation de transistors MOSSWI associés à des rails d'alimentation d'un circuit intégré de la présente invention ; et
la figure 5 illustre, par une vue de dessus très schématique, un deuxième mode de réalisation de transistors MOSSWI associés à des rails d'alimentation d'un circuit intégré selon l'invention.

Les mêmes éléments ont été désignés par les mêmes références aux différentes figures. Pour des raisons de clarté, seuls les éléments qui sont nécessaires à la compréhension de l'invention ont été représentés aux figures et sont décrits par la suite. En particulier, la fonction applicative du circuit intégré n'a pas été détaillée car elle ne fait pas l'objet de la présente invention, celle-ci s'appliquant quelle que soit l'application du circuit intégré.

Une caractéristique de la présente invention est de profiter de la surface de silicium présente sous le rail d'alimentation d'un circuit intégré pour y intégrer les transistors MOSSWI de ses éléments de protection électronique (contre des décharges électrostatiques et/ou surtensions).

Pour gagner de la place, on aura pu penser intégrer sous le rail d'alimentation, des éléments du coeur propres à l'application du circuit intégré. Toutefois, une telle solution se serait révélée insatisfaisante dans la mesure où la connexion des circuits du coeur de l'application aurait nécessité des niveaux de métallisation pour réaliser les interconnexions. Or, dans le rail d'alimentation, tous les niveaux de métallisation sont le plus souvent utilisés pour former les conducteurs (12, 13, figure 2) d'alimentation eux-mêmes afin d'en accroître l'épaisseur pour minimiser la largeur du rail d'alimentation et ainsi l'encombrement du circuit.

L'invention tire profit du fait que la réalisation des commutateurs (MOSSWI) des éléments de protection électronique (notamment ESD) et leur connexion requièrent uniquement les signaux d'alimentation positive et négative ainsi qu'un signal de commande. Or, les conducteurs d'alimentation sont déjà présents dans le rail donc à l'aplomb de la surface de silicium dans laquelle l'invention propose d'intégrer les transistors MOSSWI.

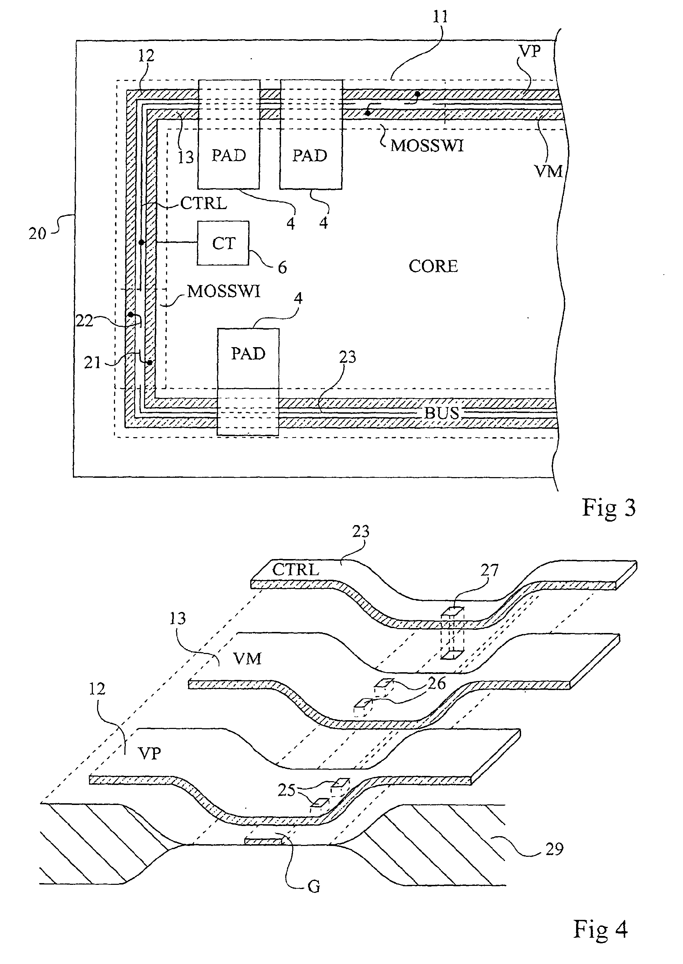

La figure 3 illustre, par une vue de dessus très schématique à rapprocher de celle de la figure 2, un mode de réalisation d'un circuit intégré 20 selon la présente invention.

On y retrouve des plots 4 (PAD) de connexion du coeur (CORE) du circuit intégré 20 vers l'extérieur, ainsi qu'un rail d'alimentation 11 (dans cet exemple, périphérique) comprenant un conducteur 12 véhiculant une tension VP d'alimentation plus positive et un conducteur 13 véhiculant une tension d'alimentation relativement plus négative VN (généralement la masse).

Selon la présente invention, les transistors MOSSWI des circuits de protection électronique (ESD et/ou surtension) sont disposés dans le rail d'alimentation 11, sous les conducteurs 12 et 13. Les connexions des transistors MOSSWI aux conducteurs 12 et 13 ont été symbolisées en figure 3 par des liaisons 21 et 22 qui sont à comparer aux liaisons 14 et 15 de la figure 2. La commande des transistors MOSSWI du circuit de l'invention est amenée par un conducteur 23 véhiculant le signal CTRL de commande fourni par un circuit 6 (CT) de commande constitué, comme précédemment, d'un circuit retardateur de type cellule RC. Le circuit 6 est, de façon classique, relié au conducteur d'alimentation bien que cela n'ait été représenté ni en figure 2 ni en figure 3.

Une caractéristique de la présente invention est qu'un seul circuit 6 de commande de protection ESD est suffisant pour l'ensemble du circuit intégré. Bien que ces circuits de commande ne constituent pas les éléments prenant le plus de place dans les solutions classiques, cela participe encore à réduire l'encombrement du circuit. On pourra toutefois maintenir le recours à plusieurs circuits de commande, par exemple, si on a besoin de réduire la résistance d'accès du signal de commande. Tous les circuits de commande sont alors reliés en parallèle au conducteur 23 de commande.

De façon similaire, un seul circuit 8 de commande de protection contre les surtensions est suffisant pour l'ensemble du circuit intégré.

Le prix à payer pour la mise en oeuvre de la présente invention est d'ajouter un conducteur dans le rail pour véhiculer le signal de commande CTRL. Toutefois, ce conducteur n'a pas besoin d'être de section importante. Par conséquent, la place qu'il occupe est faible. De plus, comme tous les niveaux de métallisation sont disponibles dans le rail, il n'est pas gênant d'allouer une petite section d'un des niveaux de métallisation pour réaliser ce signal de commande. Les deux signaux présents dans le rail de façon classique sont ceux qui, pour la mise en oeuvre de l'invention, ont besoin d'être de section importante (les conducteurs d'alimentation).

La figure 4, illustre par une vue en coupe et en perspective, la réalisation de transistors MOSSWI selon un premier mode de réalisation de l'invention. Comme l'illustre cette figure, les transistors sont réalisés perpendiculairement aux conducteurs 12 et 13 du rail d'alimentation. Cela facilite les connexions des drain et source (non détaillées) de chaque transistor par des contacts, et éventuellement des vias, respectivement 25 et 26 depuis les conducteurs 12 et 13. Ainsi, dans le mode de réalisation de la figure 4, une multitude de transistors MOS de petites dimensions sont répartis sous le rail 11 d'alimentation. Leur faible taille est compensée par une augmentation considérable de leur nombre et leur connexion en parallèle, de sorte que l'on obtient la surface de transistor voulue pour disposer une faible résistance série.

Un avantage supplémentaire de l'invention qui apparaît ici est que chaque plot 4 du circuit intégré a forcément un ensemble de transistors très proches.

Dans l'exemple de la figure 4, la connexion de la grille G des transistors est effectuée au moyen du conducteur 23 véhiculant le signal CTRL disposé latéralement par rapport aux conducteurs 12 et 13, c'est-à-dire en périphérie interne ou externe du rail d'alimentation, contrairement à ce qui est illustré par la figure 3. La connexion du conducteur 23 à la grille G s'effectue par un ou plusieurs contacts, et éventuellement vias 27. En figure 4, seules les régions d'oxyde épais 29 ont été symbolisées de part et d'autre de la grille G. Les transistors, dont la réalisation pratique dans du silicium est classique, n'ont pas été représentés en entier.

La figure 5 représente par une vue de dessus partielle et très schématique un deuxième mode de réalisation de la présente invention. Ce mode de réalisation illustre le cas où le conducteur 23 de commande des transistors MOSSWI est au centre du rail d'alimentation 11. Dans l'exemple de la figure 5, seul le rail 11 a été représenté et celui-ci a, par exemple, une structure telle que le conducteur 12 d'alimentation positive est encadré par deux conducteurs 13 de masse.

Comme dans le mode de réalisation de la figure 4, les grilles G des transistors MOSSWI sont perpendiculaires aux conducteurs du rail d'alimentation 11. Dans l'exemple de la figure 5, on a représenté plusieurs vias 27 pour connecter les grilles G au conducteur 23 tandis que l'on a représenté un seul via 25, respectivement 26, pour connecter le drain ou la source de chaque transistor aux conducteurs d'alimentation. On notera toutefois que le nombre de vias est à adapter au cas par cas en fonction des courants et de l'application. Dans l'exemple de la figure 5, on a illustré une autre série de vias 28 qui sont destinés à polariser le substrat du circuit intégré à la masse.

Un avantage de l'invention est que la surface occupée par les éléments de protection électronique (notamment ESD) par rapport à la surface du coeur destiné à l'application est nettement moindre.

Un autre avantage de l'invention est que la répartition des transistors MOSSWI des éléments de protection est plus homogène que dans un circuit classique où, pour minimiser la perte de surface, on peut être tenté de réduire le nombre d'éléments de protection.

Bien entendu, la présente invention est susceptible de diverses variantes et modifications qui apparaîtront à l'homme de l'art. En particulier, la réalisation pratique des éléments de protection électronique (ESD ou de surtension) et plus particulièrement le transistor MOSSWI est à la portée de l'homme du métier en fonction de l'application et à partir des indications fonctionnelles données ci-dessus. Celui-ci tiendra notamment compte, pour les dimensionnements du circuit de commande 6, du fait que la capacité de grille des transistors MOSSWI de l'invention est, comparativement à la surface des transistors, plus importante que pour des transistors MOSSWI classiques. De plus, bien que la réalisation des diodes D1, D2 des circuits de protection n'ait pas été illustrée aux figures, celles-ci sont, de façon classique, placées hors du rail, au plus près des plots 4.

## Revendications

1. Circuit intégré comprenant plusieurs transistors MOS (MOSSWI) de protection électronique par court-circuit de conducteurs d'alimentation (12, 13) disposés en rail,
**caractérisé en ce que** :
les transistors sont intégrés sous lesdits conducteurs en des régions où leurs grilles s'étendent perpendiculairement aux conducteurs d'alimentation et sont reliées à un conducteur (23) de commande disposé dans le rail; et
les grilles, drains et sources des transistors sont directement reliés aux conducteurs de commande et d'alimentation par des contacts (25, 26, 27).

2. Circuit selon la revendication 1, dans lequel des vias relient lesdits contacts aux conducteurs de commande et d'alimentation.

3. Circuit selon la revendication 1 ou 2, dans lequel les transistors sont commandés par au moins un premier circuit (6) commun.

4. Circuit selon la revendication 3, **caractérisé en ce que** ledit premier circuit détecte l'apparition de charges électrostatiques.

5. Circuit selon la revendication 3, **caractérisé en ce qu'**il comporte en outre au moins un deuxième circuit de commande (8) détectant l'apparition de surtensions entre lesdits conducteurs d'alimentation.

6. Circuit selon la revendication 3 ou 5, **caractérisé en ce que** le ou les circuits de commande (6, 8) des commutateurs de court-circuit sont situés dans un coeur (CORE) du circuit intégré.

## Claims

1. An integrated circuit including a plurality of MOS transistors (MOSSWI) of electronic protection by short-circuiting supply conductors (12, 13) arranged in a rail,
**characterized in that**:
the transistors are integrated under said conductors in regions where their gates extend perpendicularly to the supply conductors and are connected with a control conductor (23) disposed in the rail; and
the gates, drains and sources of the transistors are directly connected with the supply and control conductors through contacts (25, 26, 27).

2. The circuit of claim 1, wherein vias connect said contacts to the supply and control conductors.

3. The circuit of claim 1 or 2, **characterized in that** the transistors are controlled by at least one first common circuit (6).

4. The circuit of claim 3, **characterized in that** said first circuit detects the occurrence of electrostatic charges.

5. The circuit of claim 3, **characterized in that** it includes at least one second control circuit (8) detecting the occurrence of overvoltages between said supply conductors.

6. The circuit of claim 3 or 5, **characterized in that** the control circuit(s) (6, 8) of the short-circuit switches are located in a core (CORE) of the integrated circuit.

## Patentansprüche

1. Integrierter Schaltkreis mit einer Vielzahl von MOS-Transistoren (MOSSWI) zur elektronischen Sicherung durch Kurzschließen von Versorgungsleitern (12, 13), die in einer Schiene angeordnet sind,
**dadurch gekennzeichnet, dass**:
die Transistoren unter diesen Leitern in Bereichen integriert sind, wo sich deren Gates senkrecht zu den Versorgungsleitern erstrecken und mit einem Steuerleiter (23) verbunden sind, der in der Schiene angeordnet ist; und
die Gates, Drains und Sourcen der Transistoren direkt über Kontakte (25, 26, 27) mit den Versorgungs- und Steuerleitern verbunden sind.

2. Schaltkreis nach Anspruch 1, wobei Durchkontaktierungen die Kontakte mit den Versorgungs- und Steuerleitern verbinden.

3. Schaltkreis nach Anspruch 1 oder 2, **dadurch gekennzeichnet, dass** die Transistoren durch wenigstens einen ersten gemeinsamen Schaltkreis (6) gesteuert werden.

4. Schaltkreis nach Anspruch 3, **dadurch gekennzeichnet, dass** der erste Schaltkreis das Auftreten von elektrostatischer Ladungen detektiert.

5. Schaltkreis nach Anspruch 3, **dadurch gekennzeichnet, dass** er wenigstens einen zweiten Steuerschaltkreis (8) aufweist, der das Auftreten von Überspannungen zwischen den Versorgungsleitern detektiert.

6. Schaltkreis nach Anspruch 3 oder 5, **dadurch gekennzeichnet, dass** der oder die Steuerschaltkreise (6, 8) der Kurzschlussschalter in einem Kern (CORE) des integrierten Schaltkreises angeordnet sind.
